Europäisches Patentamt

European Patent Office

Office européen des brevets

(11) Publication number: **0 282 638**
**A2**

(12) **EUROPEAN PATENT APPLICATION**

(21) Application number: 87115865.5

(22) Date of filing: 29.10.87

(51) Int. Cl.4: **H05K 3/28**

(30) Priority: 16.03.87 JP 60837/87

(43) Date of publication of application:
21.09.88 Bulletin 88/38

(84) Designated Contracting States:
BE DE ES FR GB IT NL

(71) Applicant: **Nippon CMK Corp.**
**1106 Fujikubo Miyoshi-Chou**
**Iruma-Gun Saitama(JP)**

(72) Inventor: **Machida, Hideo**
**c/o 1106 Fujikubo Miyoshi-Chou**
**Iruma-Gun Saitama(JP)**
Inventor: **Kawakami, Shin**
**c/o 1106 Fujikubo Miyoshi-Chou**
**Iruma-Gun Saitama(JP)**
Inventor: **Haruyama, Satoshi**
**c/o 1106 Fujikubo Miyoshi-Chou**
**Iruma-Gun Saitama(JP)**
Inventor: **Okonogi, Hirotaka**
**c/o 1106 Fujikubo Miyoshi-Chou**
**Iruma-Gun Saitama(JP)**
Inventor: **Nikaido, Katutomo**
**c/o 1106 Fujikubo Miyoshi-Chou**
**Iruma-Gun Saitama(JP)**
Inventor: **Mukai, Norito**
**c/o 1106 Fujikubo Miyoshi-Chou**
**Iruma-Gun Saitama(JP)**

(74) Representative: **Schickedanz, Willi, Dipl.-Ing.**
**Langener Strasse 68**
**D-6050 Offenbach/Main(DE)**

(54) Printing ink for solder resist in printed circuit board.

(57) A printing ink for solder resist used in the production of printed circuit boards contains a given amount of a silicon resin and/or fluororesin in addition to ink components.

F I G.1

# PRINTING INK FOR SOLDER RESIST IN PRINTED CIRCUIT BOARD

## Technical Field to which the Invention relates

This invention relates to a printing ink for solder resist in printed circuit board or the like.

## Description of the Prior Art

In general, the printed circuit board is constructed by forming a given circuit pattern on an insulative substrate through a conductive member and assembling a given electronic part onto the circuit pattern.

The assembling of the electronic part onto the printed circuit is carried out by immersing the circuit pattern face into a melting solder bath or a jetting type solder bath to adhere the solder to the circuit pattern face at such a state that the electronic part is mounted onto the printed circuit board, whereby leads of the electronic part are electrically and mechanically connected to the circuit pattern.

Furthermore, the soldering between the circuit pattern and the lead of the electronic part is carried out by applying a solder resist to the whole surface of the circuit pattern except land portions to be soldered so as to adhere the solder only to the joint portion therebetween. However, the space between the adjoining circuit becomes narrower and also the space between the lead of the electronic part and the connecting land becomes narrower with the minuteness of the circuit pattern, and consequently the function inherent to the solder resist is damaged to cause short-circuit phenomenon between the mutual lands through the soldering and the correcting operation and the like are often required.

In order to prevent the occurrence of the short-circuit in the soldering, particularly the short-circuit of the solder at the portion having a narrow land space, therefore, there is proposed a method for the production of the printed circuit board, wherein a conductive pattern is printed onto the insulative substrate, and a first soldering resistance layer is formed on the whole surface of the conductive pattern except lands to be soldered, and a second soldering resistance layer for the prevention of short-circuit at least portion having a narrow land space is formed on the first soldering resistance layer, as disclosed in Japanese Patent Application Publication No. 54-41162.

In this method, however, the first soldering resistance layer is formed on the whole surface of the conductive pattern except the lands to be soldered, so that the higher accuracy is required in aligning operation for leaving the lands to be soldered. Furthermore, the second soldering resistance layer for the prevention of short-circuit is formed on the first soldering resistance layer after the formation thereof, so that when the second soldering resistance layer is formed with a solder resist ink by screen-printing, this ink undesirably oozes out on the land portion to be soldered.

## Technical Problem

It is an object of the invention, therefore, to solve the aforementioned drawbacks of the conventional techniques and provide a printing ink for solder resist which can develop an effect as an original solder resist without causing any troubles produced in the application of the conventional solder resist.

## Solution of the Technical Problem

According to the invention, there is the provision of a printing ink for solder resist in printed circuit boards, comprising ink components, and a silicone resin and/or fluororesin.

## Advantageous Effects of the Invention

The printing ink for solder resist in the printed circuit board according to the invention has a funtion capable of positively preventing the adhesion of a flux or a solder by properties of the silicone resin, and/or fluororesin. Particularly, when the printing ink for solder resist according to the invention is applied to a surface of the printed circuit board after the formation of circuit pattern on the other surface thereof, the intrusion of flux or solder can positively be prevented from the side of through-hole or insertion hole formed in the printed circuit board.

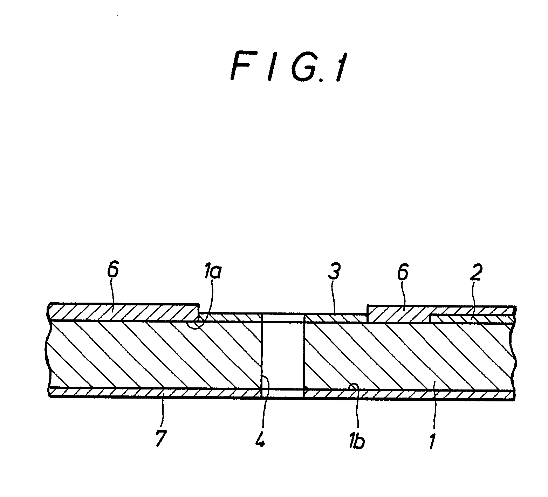

## Brief Description of the Drawing

The invention will be described with reference to the accompanying drawing, wherein:

A single figure is a partly enlarged section view of an embodiment of the printed circuit board after the application of the printing ink according to the invention.

## Preferred Embodiments of the Invention

In the single figure is shown an embodiment of the printed circuit board according to the invention, wherein numeral 1 is an insulative substrate, numeral 2 a circuit pattern formed on a surface 1a of the substrate 1 and made of a copper foil as a conductor, numeral 3 a connecting land in the circuit pattern 2, numeral 4 a through-hole opened in the connecting land 3, numeral 6 a solder resist layer coated on the surface of the circuit pattern 2, and numeral 7 a solder resist layer coated on the other surface 1b of the substrate 1.

The solder resist layer 6 is formed on the circuit pattern 2 except the connecting land 3. The solder resist layers 6 and 7 are formed by coating a printing ink containing an insulative silicone resin and/or fluororesin capable of preventing adhesion of flux and solder through a silk screen-printing or the like.

The printing ink for solder resist used in the formation of the solder resist layers 6, 7 is prepared according to a compounding recipe as mentioned below:

Preparation Example 1    Epoxy acrylate    28
(parts by weight)
     Polyethylene glycol acrylate    72
     Benzoin alkylether    4
     $TiO_2$ (Titanium oxide)    5
     $SiO_2$ (silicon oxide)    3
     Diphenyl disulfide    2
     Pigment (Cyanine Green)    0.4
     Diethyl hydroxyamine    0.1
     Dimethylsiloxane (antifoamer)    2
     Silicone high polymer resin    2 - 5

Preparation Example 2    Epoxy acrylate    28
(parts by weight)
     Polyethylene glycol acrylate    72
     Benzoin alkylether    4
     $TiO_2$    5
     $SiO_2$    3
     Diphenyl disulfide    2
     Pigment (Cyanine Green)    0.4
     Diethyl hydroxyamine    0.1
     Dimethylsiloxane    2
       Fluororesin (Florard FC-170C, trade name, made by Sumitomo 3M Co., Ltd.)    2 - 5

Preparation Example 3    Epoxy acrylate    50
(parts by weight)
     Polyurethane acrylate    50
     Benzoin methylacrylate    4
     $CaCO_3$ (Calcium carbonate)    5
     $SiO_2$    3
     Cyanine Green    0.4
     Benzothiazole    0.05
     Benzophenone    2.6
     Dimethylsiloxane    1.5
     Silicone high polymer resin    2 - 5

Preparation Example 4    Epoxy acrylate    50
(parts by weight)
     Polyurethane acrylate    50
     Benzoin methylether    4
     $CaCO_3$    5
     $SiO_2$    3
     Cyanine Green    0.4
     Benzothiazole    0.05
     Benzophenone    2.6
     Dimethylsiloxane    1.5
     Silicone high polymer resin    2 - 5
     Fluororesin (Florard FC-430)    3 - 5

According to the invention, the following resins may be used as a silicone resin or fluororesin:

Silicone resinPolon L, Polon T, KF 96, KS-700, KS-701, KS-707, KS-705F, KS-706, KS-709, KS-709S, KS-711, KSX-712, KS-62F, KS-62M, KS-64, Silicolube G-430, Silicolube G-540, Silicolube G-541, all of which are trade names made by Shin-Etsu Chemicals Industries, Ltd.; and SH-200, SH-210, SH-1109, SH-3109, SH-3107, SH-8011, FS-1265, Syli-off 23, DC pan Glaze 620, all of which are trade names made by Toray Silicon Co., Ltd.

FluororesinDaifree MS-443, MS-543, MS-743, MS-043, ME-413, ME-810, all of which are trade names made by Daikin Industries, Ltd.; Florard FC-93, FC-95, FC-98, FC-129, FC-134, FC-430, FC-431, FC-721, all of which are trade names made by Sumitomo 3M Co., Ltd.; Sumiflunon FP-81, FP-81R, FP-82, FP-84C, FP-84R, FP-86, all of which are trade names made by Sumitomo Chemicals Co., Ltd.; and Sarflon SR-100, SR-100X, which are trade names made by Kiyomi Kagaku Co., Ltd.

In the above preparation examples, the compounding amount of silicone resin and/or fluororesin is within a range of 2 - 5 parts by weight, which is confirmed to achieve the expected action. The increase of such a compounding amount comes into problem in view of economical reasons but can expect proper effect to a certain extent.

Furthermore, it has been confirmed that the contact angle of more than 90° is obtained in the solder resist ink according to the invention though the contact angle of the conventional solder resist ink is 60 - 70°.

In the printed circuit board according to the invention, the solder resist layers 6, 7 formed on both surfaces of the insulative substrate 1 are formed by coating the printing ink containing the silicone resin and/or fluororesin, so that the adhesion of flux or solder to portions except electrical connecting portion such as the connecting land 3 can positively be prevented because the flux or solder is shedded by the function inherent to the flux or solder, and hence the short-circuit phenomenon between the mutual lands with high densification of the circuit pattern can be prevented.

Further, the solder resist layers 6, 7 may be formed by coating through a means such as silk screen-printing or the like, so that this formation can advantageously be performed by the same operation as in the conventional solder resist layer.

Since the solder resist layer 7 is formed on the other surface 1b of the insulative substrate 1 opposite to the circuit pattern 2, the intrusion of the flux or solder can be prevented from the through-hole formed in the printed circuit board.

In the above illustrated embodiment, the circuit pattern 2 is formed on only the one surface 1a of the insulative substrate 1, but it may be formed on both surfaces of the substrate. Further, only the solder resist layer 6 may be formed on the side of the circuit pattern 2 in the one surface 1a of the substrate 1. Although the solder resist layers 6, 7 are formed over the whole surface of the substrate 1 as shown in the figure, the formation of the solder resist layer may be carried out only on the local portions such as high density circuit portion in the circuit pattern 2 or peripheral portion of the through-hole 4.

As mentioned above, according to the invention, the effect or preventing the wetting with flux or solder can be developed by the solder resist layer itself, so that the bridging between the circuit terminals or between terminals of electronic part is prevented in the soldering operation for the mounting of the electronic part onto the printed circuit board or for the connecting between the circuit terminals to enhance the product accuracy, and the correcting operation for bridging is omitted to improve the operability.

## Claims

1. Printing ink for solder resist in printed circuit boards, comprising ink components, and a silicone resin and/or fluororesin.

2. Printing ink according to claim 1, wherein said silicone resin and/or fluororesin is contained in an amount of 2 - 5 parts by weight per said ink components.

3. Printing ink according to claim 1, characterized by
28 parts by weight Epoxy acrylate
72 parts by weight Polyethylene glycol acrylate
4 parts by weight Benzoin alkylether
5 parts by weight TiO₂ (Titanium oxide)
3 parts by weight SiO₂ (silicon oxide)
2 parts by weight Diphenyl disulfide
0.4 parts by weight Pigment (Cyanine Green)
0.1 parts by weight Diethyl hydroxyamine
2 parts by weight Dimethylsiloxane (antifoamer)
2 - 5 parts by weight Silicone high polymer resin

4. Printing ink according to claim 1, characterized by
28 parts by weight Epoxy acrylate
72 parts by weight Polyethylene glycol acrylate
4 parts by weight Benzoin alkylether
5 parts by weight TiO₂
3 parts by weight SiO₂
2 parts by weight Diphenyl disulfide
0.4 parts by weight Pigment (Cyanine Green)
0.1 parts by weight Diethyl hydroxyamine
2 parts by weight Dimethylsiloxane
2 - 5 parts by weight Fluororesin (Florard FC-170C, trade name, made by Sumitomo 3M Co., Ltd.)

5. Printing ink according to claim 1, characterized by
50 parts by weight Epoxy acrylate
50 parts by weight Polyurethane acrylate
4 parts by weight Benzoin methylacrylate
5 parts by weight CaCO₃ (calcium carbonate)
3 parts by weight SiO₂
0.4 parts by weight Cyanine Green
0.05 parts by weight Benzothiazole
2.6 parts by weight Benzophenone
1.5 parts by weight Dimethylsiloxane
2 - 5 parts by weight Silicone high polymer resin

6. Printing ink according to claim 1, characterized by
50 parts by weight Epoxy acrylate
50 parts by weight Polyurethane acrylate
4 parts by weight Benzoin methylether
5 parts by weight CaCO₃
3 parts by weight SiO₂
0.4 parts by weight Cyanine Green
0.05 parts by weight Benzothiazole
2.6 parts by weight Benzophenone

1.5 parts by weight Dimethylsiloxane
2 - 5 parts by weight Silicone high polymer resin
3 - 5 parts by weight Fluororesin (Florard FC-430)

# F I G. 1